# EUROPEAN PATENT APPLICATION

(11) **EP 3 506 376 A1**
(43) Date of publication of application: **03.07.2019**
(21) Application number: 17843123.5
(22) Date of filing: 12.05.2017
(51) Int. Cl.: H01L 43/08, G01R 15/20, G01R 33/09, H01L 43/10

(54) **MAGNETIC SENSOR AND CURRENT SENSOR**

(30) Priority: 23.08.2016 JP 2016162642
(71) Applicant: Alps Alpine Co., Ltd., Tokyo 1458501 (JP)
(72) Inventor: IDE, Yosuke, Tokyo 145-8501 (JP)
(74) Representative: Schmitt-Nilson Schraud Waibel Wohlfrom Patentanwälte Partnerschaft mbB
(86) International application number: PCT/JP2017/017982
(87) International publication number: WO 2018/037634

(57) **Abstract**

As a magnetic sensor including a magnetoresistive effect element that hardly decreases the sensitivity even when stored under a high-temperature environment for a long time, provided is a magnetic sensor 1 including a magnetoresistive effect element GMR11 having a sensitivity axis in a specific direction. The magnetoresistive effect element GMR11 includes a first antiferromagnetic layer 24 on a free magnetic layer 23 on the side opposite to a nonmagnetic material layer 21b. The free magnetic layer 23 includes a misfit-reducing layer 23b disposed so as to be in contact with the first antiferromagnetic layer 24 and decreasing the lattice mismatch of the free magnetic layer 23 with respect to the first antiferromagnetic layer 24 and a ferromagnetic layer 23a on the misfit-reducing layer 23b on the side opposite to the first antiferromagnetic layer 24. The ferromagnetic layer 23a includes a NiFeM layer (M consists of one or more elements selected from Ta, Cr, Nb, Rh, Zr, Mo, Al, Au, Pd, Pt, and Si) 231a.

## Description

### Technical Field

The present invention relates to a magnetic sensor and a current sensor including the magnetic sensor.

### Background Art

In the field of, for example, motor drive technology in electric vehicles and hybrid cars, since relatively large currents are used, contactless current sensors capable of measuring large currents are being demanded. As such a current sensor, a sensor employing a magnetic sensor detecting the induction field from the current to be measured is known. Examples of the magnetic detection element for the magnetic sensor include magnetoresistive effect elements, such as a GMR element.

The GMR element has a layered structure composed of a fixed magnetic layer and a free magnetic layer stacked with a nonmagnetic material layer therebetween, as the basic structure. In the fixed magnetic layer, the magnetization direction is fixed in one direction by the exchange coupling bias due to a layered structure of an antiferromagnetic layer and a ferromagnetic layer or by the RKKY interaction (indirect exchange interaction) due to a self-pinned structure composed of two ferromagnetic layers stacked with a nonmagnetic intermediate layer therebetween. The free magnetic layer can change the magnetization direction according to the external magnetic field.

In a current sensor employing a magnetic sensor including a GMR element, application of an induction field from the current to be measured to the GMR element changes the magnetization direction of the free magnetic layer. The electrical resistance value of the the GMR element changes according to the relative angle between the magnetization direction of the free magnetic layer and the magnetization direction of the fixed magnetic layer. Accordingly, the magnetization direction of the free magnetic layer can be detected by measuring the electrical resistance value. It is also possible to determine the magnitude and the direction of the current to be measured giving an induction field based on the magnetization direction detected by the magnetic sensor.

Incidentally, in some electric vehicles and hybrid cars, the driving of the motor is controlled based on a current value, or the process of controlling the battery is adjusted according to a current value flowing into the battery. Accordingly, the current sensor employing a magnetic sensor is required to increase the measurement accuracy of the magnetic sensor such that the current value can be more precisely detected.

In order to improve the measurement accuracy of a magnetic sensor, it is required to achieve, for example, a decrease in offset, a reduction in the variation of output signals, and an improvement in linearity (output linearity). A preferred method for responding to these requirements is, for example, a decrease in the hysteresis of the GMR element of the magnetic sensor. Specifically, the hysteresis of the GMR element can be decreased by, for example, applying a bias magnetic field to the free magnetic layer to align the magnetization direction of the free magnetic layer even when the induction field from the current to be measured is not applied.

As a method for applying a bias magnetic field to a free magnetic layer, PTL 1 discloses a method of stacking an antiferromagnetic layer on a free magnetic layer, where the antiferromagnetic layer generates an exchange coupling bias between itself and the free magnetic layer to align the magnetization direction of the free magnetic layer in a predetermined direction in a state of permitting the magnetization to change.

### Citation List

### Patent Literature

PTL 1: Japanese Unexamined Patent Application Publication No. 2012-185044

### Summary of Invention

### Technical Problem

The method for generating an exchange coupling bias by the antiferromagnetic layer has advantages, such as uniformness of the bias magnetic field, compared to a method of generating a bias magnetic field by arranging permanent magnets in the periphery of a GMR element. However, when the GMR element is stored under a high-temperature environment for a long time, there are tendencies, as a result, to increase the bias magnetic field generated in the free magnetic layer due to the exchange coupling bias and to decrease the detection sensitivity of the GMR element.

The underlying knowledge forming the basis of the present invention is making of a single magnetic domain in a free magnetic layer based on the exchange coupling bias disclosed in PTL 1, and an object of the present invention is to provide a magnetic sensor including a magnetoresistive effect element (GMR element) that has good temperature characteristics of the offset value (the output value when no external magnetic field is applied) (which means that the offset value hardly changes with temperature change) and hardly decreases the detection sensitivity even when stored under a high-temperature (specifically, for example, 150°C) environment for a long time (specifically, for example, 1000 hours) and to provide a current sensor employing the magnetic sensor.

### Solution to Problem

The present inventors have studied in order to solve the above-described problems and, as a result, have obtained new knowledge that the presence of a certain layer in a free magnetic layer can prevent a decrease in detection sensitivity of a magnetoresistive effect element even when stored under a high-temperature environment for a long time. In addition, the inventors have also obtained new knowledge that even in such a case, a free magnetic layer including a NiFeM layer having a low temperature coefficient of resistance can improve the offset temperature characteristics of the magnetic sensor.

The present invention accomplished on the basis of such knowledge relates to, in one aspect, a magnetic sensor comprising a magnetoresistive effect element having a sensitivity axis in a specific direction, wherein the magnetoresistive effect element has a layered structure composed of a fixed magnetic layer and a free magnetic layer stacked with a nonmagnetic material layer therebetween on a substrate and includes a first antiferromagnetic layer on the free magnetic layer on the side opposite to the nonmagnetic material layer so as to generate an exchange coupling bias between itself and the free magnetic layer to align the magnetization direction of the free magnetic layer in a predetermined direction in a state of permitting the magnetization to change; the free magnetic layer includes a misfit-reducing layer disposed so as to be in contact with the first antiferromagnetic layer and decreasing the lattice mismatch of the free magnetic layer with respect to the first antiferromagnetic layer and a ferromagnetic layer consisting of a ferromagnetic material disposed on the misfit-reducing layer on the side opposite to the first antiferromagnetic layer; and the ferromagnetic layer includes a NiFeM layer (a layer consisting of NiFeM, where M is one or more elements selected from Ta, Cr, Nb, Rh, Zr, Mo, Al, Au, Pd, Pt, and Si).

The lattice mismatch of the free magnetic layer with respect to the first antiferromagnetic layer is decreased by the misfit-reducing layer provided to the free magnetic layer so as to be in contact with the first antiferromagnetic layer. As a result, the detection sensitivity of the magnetoresistive effect element is hardly decreased even when stored at a high temperature of about 150°C for a long time of about 1000 hours. In addition, since the ferromagnetic layer of the free magnetic layer includes a NiFeM layer having a low temperature coefficient of resistance, the offset temperature characteristics (unit: µV/°C) of the magnetic sensor can be improved (decreasing it close to zero).

In the magnetic sensor, the misfit-reducing layer and the ferromagnetic layer each preferably have a face-centered cubic (fcc) structure, and the lattice spacing of the fcc(111) plane of the misfit-reducing layer is preferably larger than that of the fcc(111) plane of the ferromagnetic layer.

In the magnetic sensor, the misfit-reducing layer preferably contains one or more iron group elements and one or more platinum group elements.

The present invention relates to, in another aspect, a magnetic sensor including a magnetoresistive effect element having a sensitivity axis in a specific direction, wherein the magnetoresistive effect element has a layered structure composed of a fixed magnetic layer and a free magnetic layer stacked with a nonmagnetic material layer therebetween on a substrate and includes a first antiferromagnetic layer on the free magnetic layer on the side opposite to the nonmagnetic material layer so as to generate an exchange coupling bias between itself and the free magnetic layer to align the magnetization direction of the free magnetic layer in a predetermined direction in a state of permitting the magnetization to change; the free magnetic layer includes a first layer containing one or more iron group elements and one or more platinum group elements and disposed so as to be in contact with the first antiferromagnetic layer and a ferromagnetic layer consisting of a ferromagnetic material disposed on the first layer on the side opposite to the first antiferromagnetic layer; and the ferromagnetic layer includes a NiFeM layer (a layer consisting of NiFeM, where M is one or more elements selected from Ta, Cr, Nb, Rh, Zr, Mo, Al, Au, Pd, Pt, and Si) .

The lattice mismatch of the free magnetic layer with respect to the first antiferromagnetic layer is decreased by the first layer provided to the free magnetic layer so as to be in contact with the first antiferromagnetic layer. As a result, the detection sensitivity of the magnetoresistive effect element is hardly decreased even when stored at a high temperature of about 150°C for a long time of about 1000 hours. In addition, since the ferromagnetic layer of the free magnetic layer includes a NiFeM layer having a low temperature coefficient of resistance, the offset temperature characteristics (unit: µV/°C) of the magnetic sensor can be improved (decreasing it close to zero).

In the magnetic sensor, the first antiferromagnetic layer preferably contains a platinum group element and Mn.

In the magnetic sensor, the first antiferromagnetic layer is preferably formed of at least one of IrMn and PtMn.

In the magnetic sensor, the NiFeM layer may be constituted of NiFeNb. Since NiFeNb has a particularly low temperature coefficient of resistance, such a layer is preferred from the viewpoint of improving the offset temperature characteristics of the magnetic sensor.

In the magnetic sensor, the ferromagnetic layer preferably further includes a conductive ferromagnetic layer located to be closer to the nonmagnetic material layer side than the NiFeM layer and having an electrical resistivity lower than that of the NiFeM layer. In such a case, a GMR effect readily occurs. In such a case, it is preferable that the conductive ferromagnetic layer be located so as to be in contact with the nonmagnetic material layer, that is, a ferromagnetic layer having a relatively low conductivity be not present between the conductive ferromagnetic layer and the nonmagnetic material layer. A specific example of the conductive ferromagnetic layer is a CoFe layer.

The conductive ferromagnetic layer preferably contains a CoFe alloy having a face-centered cubic structure from the viewpoint of reducing the influence of external stress on the magnetic sensor. In some particularly preferred cases, the conductive ferromagnetic layer consists of a CoFe alloy having a face-centered cubic structure and has a thickness of 10 angstroms or more and 40 angstroms or less.

The present invention relates to, in further another aspect, a current sensor including the magnetic sensor according to the present invention.

### Advantageous Effects of Invention

According to the present invention, provided is a magnetic sensor comprising a magnetoresistive effect element having good offset temperature characteristics and hardly decreasing the sensitivity even when stored under a high-temperature environment for a long time, while being a system causing an exchange coupling bias in the free magnetic layer. In addition, a current sensor employing the magnetic sensor is also provided.

### Brief Description of Drawings

Fig. 1 is a circuit diagram of a magnetic sensor according to an embodiment of the present invention.
Fig. 2 is an enlarged plan view of a magnetoresistive effect element of the magnetic sensor shown in Fig. 1.
Fig. 3 is a cross-sectional view taken along the line II-II shown in Fig. 2.
Fig. 4 is a graph showing temperature characteristics of the sensor output Vₒᵤₜ values of a magnetic sensor according to Example 1 and a magnetic sensor according to Comparative Example 1 in a state where no external magnetic field is applied.
Fig. 5 is a graph showing the results of Example 2.
Fig. 6 is a graph showing the results of Example 3.

### Description of Embodiments

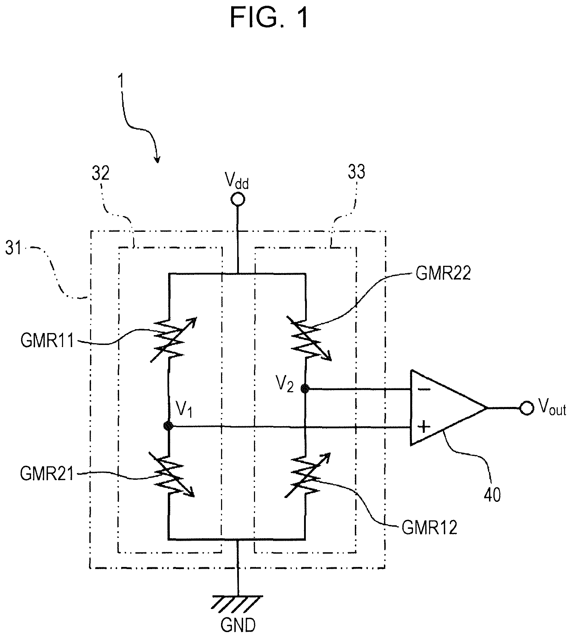

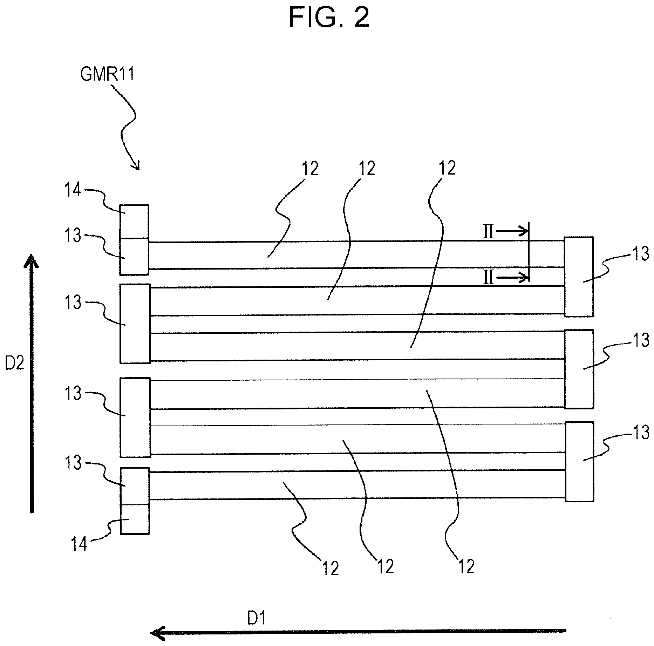

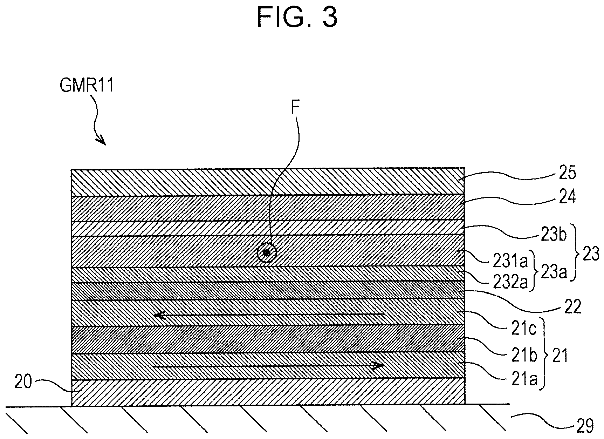

Fig. 1 is a circuit diagram of a magnetic sensor according to an embodiment of the present invention, Fig. 2 is a conceptual diagram (plan view) of a magnetoresistive effect element in the magnetic sensor shown in Fig. 1, and Fig. 3 is a cross-sectional view taken along the line II-II shown in Fig. 2.

A magnetic sensor 1 according to an embodiment of the present invention has, as shown in Fig. 1, a full-bridge circuit 31 including two types of magnetoresistive effect elements each composed of two (first magnetoresistive effect elements GMR11 and GMR12 and second magnetoresistive effect elements GMR21 and GMR22).

The first magnetoresistive effect element GMR11 and the second magnetoresistive effect element GMR21 are connected in series to form a first half bridge circuit 32 from which a first midpoint potential V₁ is output, and the first magnetoresistive effect element GMR12 and the second magnetoresistive effect element GMR22 are connected in series to form a second half bridge circuit 33 from which a second midpoint potential V₂ is output. The first half bridge circuit 32 and the second half bridge circuit 33 are connected in parallel between the input terminal V_{dd} and the ground terminal GND to constitute a full-bridge circuit 31.

As shown in Fig. 1, the difference between the first midpoint potential V₁ and the second midpoint potential V₂ is amplified by a differential amplifier 40 and is output as a sensor output Vₒᵤₜ. In the embodiment, although the full-bridge circuit 31 is composed of four magnetoresistive effect elements (first magnetoresistive effect elements GMR11 and GMR12 and second magnetoresistive effect elements GMR21 and GMR22), the circuit is not limited thereto and may employ a large number of magnetoresistive effect elements for increasing the output.

The structures of the magnetic sensitive parts (long patterns 12 described below) are common in the first magnetoresistive effect elements GMR11 and GMR12 and the second magnetoresistive effect elements GMR21 and GMR22, and the directions of magnetization in setting the direction of sensitivity axis are opposite to each other. Consequently, the detection sensitivities of the four magnetoresistive effect elements (first magnetoresistive effect elements GMR11 and GMR12 and second magnetoresistive effect elements GMR21 and GMR22) are equal to each other in principle. Accordingly, since the first midpoint potential V₁ and the second midpoint potential V₂ are equal to each other when no external magnetic field is applied, the potential of the sensor output Vₒᵤₜ is 0 V in principle. Application of an external magnetic field increases the difference between the first midpoint potential V₁ and the second midpoint potential V₂ depending on the intensity thereof, and the potential of the sensor output Vₒᵤₜ departs from 0 V and reaches a potential according to the intensity of the external magnetic field. Accordingly, the intensity of the applied external magnetic field can be determined by measuring the potential of the sensor output Vₒᵤₜ.

The structures of the four magnetoresistive effect elements (first magnetoresistive effect elements GMR11 and GMR12 and second magnetoresistive effect elements GMR21 and GMR22) of the magnetic sensor 1 will be described using Figs. 2 and 3. As described above, since the structures of the magnetic sensitive parts are common in the four magnetoresistive effect elements, the first magnetoresistive effect element GMR11 will now be described as an example.

The first magnetoresistive effect element GMR11 includes a plurality of belt-like long patterns 12 (stripes) and has a shape (meander shape) formed by the plurality of longitudinal patterns 12 (stripes) turning back such that the stripe longitudinal directions D1 (hereinafter, also simply referred to as "longitudinal directions D1") are arranged in parallel to each other. In the first magnetoresistive effect element GMR11 of this meander shape, the sensitivity axis direction is a direction D2 (hereinafter, also simply referred to as "width direction D2") orthogonal to longitudinal direction D1 of the long patterns 12. This is also common in the first magnetoresistive effect element GMR12 and the second magnetoresistive effect elements GMR21 and GMR22 having the same basic structures as that of the first magnetoresistive effect element GMR11. Accordingly, in the use of the magnetic sensor 1 including the first magnetoresistive effect element GMR11 of the meander shape, the magnetic field to be measured and the cancellation magnetic field are applied along the width direction D2.

Among the plurality of belt-like long patterns 12 arranged in parallel to each other, the long patterns 12 other than those located at the ends in the arrangement direction are each connected to adjacent belt-like long pattern 12 at the end via a conductive part 13. The long patterns 12 located at the ends in the arrangement direction are each connected to a connecting terminal 14 via a conductive part 13. The first magnetoresistive effect element GMR11 thus has a structure in which a plurality of long patterns 12 are connected in series via conductive parts 13 between two connecting terminals 14, 14. The conductive parts 13 and the connecting terminals 14 may be either nonmagnetic or magnetic, but are preferably made of materials having low electrical resistance.

One of the two connecting terminals 14, 14 of the first magnetoresistive effect element GMR11 is connected to an input terminal V_{dd}, and the other is connected to a part that outputs a first midpoint potential V₁. When the magnetic sensor 1 is used, the signal from the first magnetoresistive effect element GMR11 is input into a differential amplifier 40 as the first midpoint potential V₁, and a sensor output Vₒᵤₜ is calculated from the difference between the first midpoint potential V₁ and the second midpoint potential V₂.

As shown in Fig. 3, each of the long patterns 12 of the first magnetoresistive effect element GMR11 is formed on a substrate 29 with, for example, an insulating layer (not shown) therebetween by forming a seed layer 20, a fixed magnetic layer 21, a nonmagnetic material layer 22, a free magnetic layer 23, a first antiferromagnetic layer 24, and a protective layer 25 in this order from the bottom. These layers may be formed by any methods and may be formed by, for example, sputtering.

The seed layer 20 is formed of, for example, NiFeCr or Cr.

The fixed magnetic layer 21 has a self-pinned structure composed of a first magnetic layer 21a, a second magnetic layer 21c, and a nonmagnetic intermediate layer 21b located between the first magnetic layer 21a and the second magnetic layer 21c. As shown in Fig. 3, the fixed magnetization direction (in Fig. 3, rightward) of the first magnetic layer 21a and the fixed magnetization direction (in Fig. 3, leftward) of the second magnetic layer 21c are antiparallel to each other. The fixed magnetization direction of the second magnetic layer 21c is the fixed magnetization direction, i.e., the sensitivity axis direction, of the fixed magnetic layer 21.

In the first magnetoresistive effect element GMR12, the fixed magnetization direction in the fixed magnetic layer 21 is the same direction as that in the first magnetoresistive effect element GMR11. That is, the structure including the magnetization of the first magnetoresistive effect element GMR12 is common to that of the first magnetoresistive effect element GMR11. In contrast, in the second magnetoresistive effect elements GMR21 and GMR22, the fixed magnetization direction of the fixed magnetic layer 21 is opposite (antiparallel) to that in the first magnetoresistive effect elements GMR11 and GMR12. Accordingly, when an external magnetic field is applied along the sensitivity axis direction, the directions of resistance change due to an external magnetic field are opposite in the first magnetoresistive effect elements GMR11 and GMR12 and the second magnetoresistive effect elements GMR21 and GMR22.

As shown in Fig. 3, the first magnetic layer 21a is disposed on the seed layer 20, and the second magnetic layer 21c is disposed so as to be in contact with the nonmagnetic material layer 22 described below. The first magnetic layer 21a is preferably made of a CoFe alloy, which is a material having a coercivity higher than that of the second magnetic layer 21c.

The second magnetic layer 21c being in contact with the nonmagnetic material layer 22 is a layer contributing to a magneto-resistance effect (specifically, GMR effect) and is made of a magnetic material capable of increasing the mean free path difference between up-spin conduction electrons and down-spin conduction electrons.

The first magnetoresistive effect element GMR11 shown in Fig. 3 is adjusted such that the difference between the magnetization amounts (saturated magnetization Ms × layer thickness t) of the first magnetic layer 21a and the second magnetic layer 21c is substantially zero.

The fixed magnetic layer 21 of the first magnetoresistive effect element GMR11 shown in Fig. 3 has a self-pinned structure and therefore does not include an antiferromagnetic layer. Consequently, the temperature characteristics of the first magnetoresistive effect element GMR11 are not restricted by the blocking temperature of the antiferromagnetic layer.

In order to enhance the magnetization fixing power of the fixed magnetic layer 21, it is important to increase the coercivity Hc of the first magnetic layer 21a, to adjust the difference between the magnetization amounts of the first magnetic layer 21a and the second magnetic layer 21c to be substantially zero, and further to adjust the thickness of the nonmagnetic intermediate layer 21b such that the antiparallel coupling magnetic field due to the RKKY interaction caused between the first magnetic layer 21a and the second magnetic layer 21c is enhanced. Such appropriate adjustment prevents the fixed magnetic layer 21 from being affected by outside magnetic fields and further strongly fixes the magnetization.

The nonmagnetic material layer 22 is made of, for example, copper (Cu).

The free magnetic layer 23 of the first magnetoresistive effect element GMR11 shown in Fig. 3 is composed of a ferromagnetic layer 23a and a misfit-reducing layer 23b. The ferromagnetic layer 23a of the first magnetoresistive effect element GMR11 in the magnetic sensor 1 according to an embodiment of the present invention includes a NiFeM layer (a layer consisting of NiFeM, where M is one or more elements selected from Ta, Cr, Nb, Rh, Zr, Mo, Al, Au, Pd, Pt, and Si) 231a and a conductive ferromagnetic layer 232a. The ferromagnetic layer 23a is exchange coupled to the first antiferromagnetic layer 24 together with the misfit-reducing layer 23b.

The variation in the thickness of each layer (such as fixed magnetic layer 21, free magnetic layer 23, and first antiferromagnetic layer 24) constituting the first magnetoresistive effect element GMR11 would cause a characteristic variation of the first magnetoresistive effect element GMR11. In the circuit having a full-bridge structure of the magnetic sensor 1 shown in Fig. 1, if the thickness of each film constituting each of the four magnetoresistive effect elements (first magnetoresistive effect elements GMR11 and GMR12 and second magnetoresistive effect elements GMR21 and GMR22) constituting the circuit is uniform without variation, the potential of the sensor output Vₒᵤₜ when no external magnetic field is applied is 0 V. However, practically, variations in the manufacturing process cause a variation in the thickness of each layer constituting each magnetoresistive effect element. Due to this variation in the thickness of each layer, the potential of the sensor output Vₒᵤₜ when no external magnetic field is applied does not become 0 V and has a prescribed offset value.

In addition, the offset value varies according to a change in the environmental temperature, and the ease of change (offset temperature characteristics) is also affected by the variation in each magnetoresistive effect element. The offset temperature characteristics are readily affected by the temperature coefficient of resistance (unit: 10⁻⁶/°C) of the materials constituting each layer of the magnetoresistive effect element. Specifically, in the plurality of magnetoresistive effect elements of the magnetic sensor, when the thicknesses of the layers made of materials having relatively large temperature coefficients of resistance differ from each other, the offset temperature characteristics of the magnetic sensor are high (the offset value readily changes depending on the change of the environmental temperature).

The ferromagnetic layer 23a is formed so as to have a relatively large thickness (e.g., 5 angstroms or more) among the layers of the first magnetoresistive effect element GMR11 from the viewpoint of appropriately forming a spin valve in the first magnetoresistive effect element GMR11. Accordingly, the ferromagnetic layer 23a is readily affected by the variation in the manufacturing process and is a layer having a relatively variation of the thickness. When the temperature coefficient of resistance of such a layer having a relatively large variation of the thickness is large, the offset temperature characteristics of the magnetic sensor 1 including a plurality of the resulting magnetoresistive effect elements readily become relatively high (the change in the offset value based on temperature change is large).

Accordingly, the ferromagnetic layer 23a of the first magnetoresistive effect element GMR11 in the magnetic sensor 1 according to an embodiment of the present invention includes a NiFeM layer 231a having a relatively small temperature coefficient of resistance. The NiFeM layer 231a has a relatively small temperature coefficient of resistance compared to other ferromagnetic materials that can be used as the structural material of the ferromagnetic layer 23a, specifically, for example, NiFe (Ni_{82.5}Fe_{17.5}) and 90CoFe (Co₉₀Fe₁₀).

Accordingly, even if each NiFeM layer 231a in the four magnetoresistive effect elements of the magnetic sensor 1 has a variation in the thickness, the variation in the thickness hardly affects the offset temperature characteristics. The element constituting M in the NiFeM layer 231a may be a single element or a combination of two or more elements. The atomic ratio of the elements constituting M is arbitrary as long as the NiFeM layer 231a has appropriate magnetic characteristics (showing ferromagnetism). From the viewpoint of more stably satisfying the decrease of the temperature coefficient of resistance and showing ferromagnetism, M in the NiFeM layer 231a is preferably Nb, that is, the NiFeM layer 231a preferably consists of NiFeNb.

The ferromagnetic layer 23a of the first magnetoresistive effect element GMR11 in the magnetic sensor 1 according to an embodiment of the present invention includes a conductive ferromagnetic layer 232a located closer to the nonmagnetic material layer 22 side than the NiFeM layer 231a and having an electrical resistivity lower than that of the NiFeM layer 231a. Since the conductive ferromagnetic layer 232a is located on the nonmagnetic material layer 22 side than the NiFeM layer 231a, a region having a large spin-dependent scattering by a GMR effect can be stably ensured. Examples of the conductive ferromagnetic layer 232a include a layer consisting of a CoFe alloy (CoFe layer), such as 90CoFe (Co₉₀Fe₁₀). The conductive ferromagnetic layer 232a is preferably located so as to be in contact with the nonmagnetic material layer 22 from the viewpoint of more stably ensuring a region having a large spin-dependent scattering by a GMR effect. In the case of thus including the conductive ferromagnetic layer 232a, the NiFeM layer 231a is preferably constituted of a material having a relatively high electrical resistivity from the viewpoint of decreasing the shunt loss. Also from this viewpoint, the element constituting M in the NiFeM layer 231a is preferably Nb, that is, the NiFeM layer 231a preferably consists of NiFeNb.

Here, as described below, from the viewpoint of reducing the influence of external stress on the magnetic sensor 1, the conductive ferromagnetic layer 232a preferably contains a CoFe alloy having a face-centered cubic (fcc) structure. The fcc structure of the CoFe alloy is stable when the Co content is 80 atm% or more, such as the above-mentioned 90CoFe (Co₉₀Fe₁₀). The magnetostriction constant λs of a CoFe alloy having an fcc structure is lower than that of a CoFe alloy having a bcc structure (the absolute value is low). Accordingly, when the conductive ferromagnetic layer 232a dominantly contains a CoFe alloy having an fcc structure, magnetoelastic anisotropy (reverse magnetostrictive effect) is hardly actualized in the free magnetic layer 23, even if the first magnetoresistive effect element GMR11 receives stress from the outside. If the reverse magnetostrictive effect is actualized, the magnetization direction of the free magnetic layer 23 readily changes based on external stress, and therefore the characteristics stability of the first magnetoresistive effect element GMR11 decreases. As a result, the sensitivity of the first magnetoresistive effect element GMR11 against an external magnetic field may decrease. Examples of the case of applying external stress to the first magnetoresistive effect element GMR11 include packaging of a chip including the first magnetoresistive effect element GMR11 in a resin mold. When the conductive ferromagnetic layer 232a contains a CoFe alloy having an fcc structure, even if a resin is molded under conditions of applying stress to the first magnetoresistive effect element GMR11 in the packaging step, which hardly causes a problem of increasing the variation in the characteristics resulting from the stress.

In the case of the conductive ferromagnetic layer 232a containing a CoFe alloy having an fcc structure, the specific composition and thickness of the conductive ferromagnetic layer 232a may be appropriately set such that the magnetostriction constant λs of the free magnetic layer 23 is as small as possible. For example, when the conductive ferromagnetic layer 232a consists of 90CoFe(Co₉₀Fe₁₀), the resistance changing rate ΔR/R of the first magnetoresistive effect element GMR11 can be increased within a thickness range of 10 angstroms or more and 40 angstroms or less, preferably 20 angstroms or more and 30 angstroms or less, of the conductive ferromagnetic layer 232a. In addition, in the case of the conductive ferromagnetic layer 232a having a layered structure composed of a lower layer (fcc structure) consisting of 90CoFe(Co₉₀Fe₁₀) and an upper layer (bcc structure) consisting of 70CoFe(Co₇₀Fe₃₀), if the upper layer has a thickness smaller than a certain level, the 70CoFe layer is formed under influence of 90CoFe as the lower layer and tends to grow as an fcc structure, and the magnetostriction constant λs of the free magnetic layer 23 is therefore small. However, if the upper layer has a thickness larger than a certain level, the amount of component having a bcc structure, which is stable in 70CoFe(Co-₇₀Fe₃₀), increases, and the magnetostriction constant λs of the free magnetic layer 23 is therefore large. This viewpoint will be described in detail in Examples.

The misfit-reducing layer 23b is a layer for decreasing lattice mismatch of the free magnetic layer 23 with respect to the first antiferromagnetic layer 24. In the first magnetoresistive effect element GMR11 of the magnetic sensor 1 according to an embodiment of the present invention, the misfit-reducing layer 23b is disposed so as to be in contact with the first antiferromagnetic layer 24.

Regarding the lattice mismatch of the free magnetic layer with respect to the first antiferromagnetic layer, a case in which the material constituting the free magnetic layer includes NiFe and the material constituting the first antiferromagnetic layer is IrMn will be described as an example. The X-ray diffraction spectrum measured for a layered product of the free magnetic layer including NiFe and the first antiferromagnetic layer consisting of IrMn has a peak based on the fcc(111) plane of the free magnetic layer at approximately 51.5° and a peak based on the fcc(111) plane of the first antiferromagnetic layer at approximately 48.5°. The lattice spacings calculated based on these measurement results are 2.18 angstroms in the IrMn constituting the first antiferromagnetic layer and 2.06 angstroms in the NiFe constituting the free magnetic layer, and lattice mismatch is estimated to be about 6%.

In contrast, when the free magnetic layer 23 includes the misfit-reducing layer 23b as in the first magnetoresistive effect element GMR11, in the X-ray diffraction spectrum measured for a layered product of the free magnetic layer 23 and the first antiferromagnetic layer consisting 24 consisting of IrMn, the peak based on the free magnetic layer 23 shifts to the low-angle side to reduce the lattice mismatch between the free magnetic layer 23 and the first antiferromagnetic layer 24. The first magnetoresistive effect element GMR11 is constituted, in one specific example, such that the lattice spacing of the misfit-reducing layer 23b is larger than that of the ferromagnetic layer 23a. It is assumed that since the lattice spacing of the misfit-reducing layer 23b is larger than that of the ferromagnetic layer 23a, the lattice spacing of the free magnetic layer 23 including the misfit-reducing layer 23b and the ferromagnetic layer 23a increases to approach the lattice spacing of the first antiferromagnetic layer 24 and reduces the lattice mismatch between the free magnetic layer 23 and the first antiferromagnetic layer 24. Thus, in a specific example, the lattice spacing in the fee(111) plane of the misfit-reducing layer 23b is larger than that in the fee(111) plane of the ferromagnetic layer 23a.

By thus-decreasing the lattice mismatch between the free magnetic layer 23 and the first antiferromagnetic layer 24, the magnetic sensor 1 including the first magnetoresistive effect element GMR11 hardly decreases the detection sensitivity when stored under a high-temperature environment for a long time, compared to the case of large lattice mismatch.

The detection sensitivity of the magnetic sensor 1 stored under a high-temperature environment for a long time is prevented from decreasing by a reduction in the lattice mismatch between the free magnetic layer 23 and the first antiferromagnetic layer 24 is probably caused by that the lattice matching of the free magnetic layer 23 with the first antiferromagnetic layer 24 is increased and as a result, the atoms contained in the first antiferromagnetic layer 24 are hindered from moving to decrease the change of the exchange coupling magnetic field after storage under a high-temperature environment for a long time.

The misfit-reducing layer 23b may have any composition that can contribute to a reduction in the lattice mismatch between the free magnetic layer 23 and the first antiferromagnetic layer 24. As described above, the misfit-reducing layer 23b preferably contains a material having an atomic radius larger than that of the material constituting the ferromagnetic layer 23a. The misfit-reducing layer 23b may have a monolayer structure or may have a layered structure. When the material constituting the ferromagnetic layer 23a is a NiFe-based material (including NiFeM) or a CoFe-based material and the material constituting the first antiferromagnetic layer 24 is IrMn or PtMn, the misfit-reducing layer 23b may include a first layer containing one or more iron group elements (specifically, for example, Fe, Ni, and Co) and one or more platinum group elements (specifically, for example, Pt, Pd, Rh, Ir, Ru, and Os). Examples of the first layer include CoFePt and NiFePt. The lattice spacing of the fcc(111) plane of Pt is 2.26 angstroms and when the material constituting the first antiferromagnetic layer 24 is IrMn as described above, the lattice spacing of the fcc(111) plane of the first antiferromagnetic layer 24 is approximately 2.18 angstroms. Accordingly, if the misfit-reducing layer 23b includes the first layer containing a platinum group element, such as Pt, together with an iron group element, the lattice spacing of the fcc(111) plane of the misfit-reducing layer 23b increases according to the content of the platinum group element, and as a result, the lattice spacing of the fcc(111) plane of the free magnetic layer 23 also increases. If the first layer is made of NiFeX (X is one or more elements selected from platinum group elements), the temperature coefficient of resistance is relatively low. Accordingly, the first layer has the same functions as that of the misfit-reducing layer 23b and can contribute to improvement of the offset temperature characteristics of the magnetic sensor 1, as in the NiFeM layer 231a of the ferromagnetic layer 23a.

The relationship between the content of the iron group element and the content of the platinum group element in the first layer is not limited as long as the lattice spacing of the fcc(111) plane of the free magnetic layer 23 can be increased, as described above, and the free magnetic layer 23 has appropriate magnetic characteristics, specifically, an exchange coupling is appropriately generated between the free magnetic layer 23 and the first antiferromagnetic layer 24. As described in Examples below, the lattice mismatch between the fcc(111) plane of the free magnetic layer 23 consisting of the first layer and the fcc(111) plane of the first antiferromagnetic layer 24 consisting of IrMn can be reduced by increasing the content of the platinum group element in the first layer. At the same time, however, an increase in the content of the platinum group element in the first layer may cause a reduction in the saturated magnetization Ms (unit: T) of the free magnetic layer 23. In such a case, an excessive increase in the content of the platinum group element in the first layer prevents appropriate generation of an exchange coupling bias in the free magnetic layer 23.

The misfit-reducing layer 23b may have any thickness that can contribute to a reduction in the lattice mismatch between the free magnetic layer 23 and the first antiferromagnetic layer 24. The thickness may be appropriately determined considering that an excessively thin misfit-reducing layer 23b is difficult to reduce the lattice mismatch between the free magnetic layer 23 and the first antiferromagnetic layer 24 and an excessively thick misfit-reducing layer 23b increases a risk of failing to appropriately generate an exchange coupling bias in the free magnetic layer 23. When the material constituting the ferromagnetic layer 23a includes an NiFe-based material (including NiFeM) or a CoFe-based material, the material constituting the first antiferromagnetic layer 24 consists of IrMn or PtMn, and the misfit-reducing layer 23b consists of CoFePt, the misfit-reducing layer 23b preferably has a thickness of 3 angstroms or more and 100 angstroms or less.

The protective layer 25 may be made of any material. Examples thereof include Ta (tantalum). The magnetization direction F of the free magnetic layer 23 in the first magnetoresistive effect element GMR11 shown in Fig. 2 is the initial magnetization direction, and the magnetization direction F of the free magnetic layer 23 is aligned in a direction orthogonal to the fixed magnetization direction (the fixed magnetization direction of the second magnetic layer 21c) of the fixed magnetic layer 21.

In the first magnetoresistive effect element GMR11 shown in Fig. 3, although the first antiferromagnetic layer 24 is formed on the entire upper surface of the free magnetic layer 23, the first antiferromagnetic layer 24 is not limited thereto and may be formed discontinuously on the upper surface of the free magnetic layer 23. However, the first antiferromagnetic layer 24 formed on the entire surface of the free magnetic layer 23 can appropriately make the whole free magnetic layer 23 into a single magnetic domain in one direction and can further reduce the hysteresis and therefore can preferably improve the measurement accuracy.

The magnetoresistive effect element of the magnetic sensor according to an embodiment of the present invention may be produced by any method. The magnetoresistive effect element (first magnetoresistive effect element GMR11) of the magnetic sensor according to the embodiment can be efficiently produced according to the method described below.

A seed layer 20 is formed on an insulating layer (not shown in Fig. 3) provided on a substrate 29, and a fixed magnetic layer 21 having a self-pinned structure is stacked thereon. Specifically, as shown in Fig. 3, a first magnetic layer 21a, a nonmagnetic intermediate layer 21b, and a second magnetic layer 21c are sequentially stacked. Each layer may be formed by any method, and examples thereof include sputtering. The second magnetic layer 21c can be strongly magnetized in a direction antiparallel to the magnetization direction of the first magnetic layer 21a by the RKKY interaction, by forming the first magnetic layer 21a under application of a magnetic field such that the first magnetic layer 21a is magnetized along the width direction D2 in Fig. 2. The thus-magnetized second magnetic layer 21c can maintain the state of being magnetized in the width direction D2 even if a magnetic field in a direction different from the magnetization direction of the second magnetic layer 21c itself is applied during the subsequent production procedure, without being influenced by the magnetic field.

Subsequently, a nonmagnetic material layer 22 is stacked on the fixed magnetic layer 21. The nonmagnetic material layer 22 may be stacked by any method, and examples thereof include sputtering.

Subsequently, a free magnetic layer 23 (a conductive ferromagnetic layer 232a, a NiFeM layer 231a, and a misfit-reducing layer 23b), a first antiferromagnetic layer 24, and a protective layer 25 are sequentially stacked on the nonmagnetic material layer 22 under application of a magnetic field in a direction along the longitudinal direction D1. These layers may be stacked by any method, and examples thereof include sputtering. By thus-forming the layers in a magnetic field, an exchange coupling bias is generated between the free magnetic layer 23 and the first antiferromagnetic layer 24 in a direction along the magnetization direction of the free magnetic layer 23. During the formation of these layers, although a magnetic field is also applied to the fixed magnetic layer 21, since the fixed magnetic layer 21 has a pinned structure due to the RKKY interaction, the magnetization direction is not changed by this applied magnetic field. When the misfit-reducing layer 23b of the free magnetic layer 23 includes a first layer formed by simultaneous deposition of an iron group element and a platinum group element, such as CoFePt or NiFePt, the alloy composition of the first layer can be adjusted by controlling the deposition rate (specifically, for example, sputtering rate) of the iron group element and the deposition rate (specifically, for example, sputtering rate) of the platinum group element.

Here, when an IrMn-based material is used as the material constituting the first antiferromagnetic layer 24, the exchange coupling direction of the first antiferromagnetic layer 24 can be aligned by forming the film in a magnetic field not accompanied by particular heat treatment. Accordingly, it is possible not to perform annealing in a magnetic field throughout the whole process of producing the first magnetoresistive effect element GMR11. Magnetoresistive effect elements (second magnetoresistive effect elements GMR21 and GMR22) having different sensitivity axes (including a case in which the magnetization directions are opposite) can be easily produced on a single substrate 29 by performing the process of producing the first magnetoresistive effect element GMR11 by an annealing-free process in a magnetic field.

The free magnetic layer 23 and the first antiferromagnetic layer 24 are thus-formed in a magnetic field, and a protective layer 25 is then finally stacked. The protective layer 25 may be stacked by any method, and examples thereof include sputtering.

The layered structure obtained by the film-forming process described above is subjected to removal processing (milling) and is formed into a plurality of long patterns 12 arranged along the width direction of D2. Conductive parts 13 connecting these long patterns 12 and connecting terminals 14 connecting to the conductive parts 13 are formed to give a first magnetoresistive effect element GMR11 having a meander shape shown in Fig. 2.

The magnetic sensor including the magnetoresistive effect element according to an embodiment of the present invention can be suitably used as a current sensor. In such a current sensor, as shown in Fig. 1, four magnetoresistive effect elements (first magnetoresistive effect elements GMR11 and GMR12 and second magnetoresistive effect elements GMR21 and GMR22) are preferably used to form a bridge circuit for enhancing the measurement accuracy. A preferred example of the method of producing a magnetoresistive effect element according to an embodiment of the present invention does not include annealing in a magnetic field and therefore can easily produce a plurality of magnetoresistive effect elements on a single substrate.

Examples of the current sensor according to an embodiment of the present invention include a magnetic proportional current sensor and a magnetic balance current sensor.

The magnetic proportional current sensor includes at least one magnetoresistive effect element according to an embodiment of the present invention and includes a magnetic field detecting bridge circuit having two outputs for generating a potential difference according to the induction field from a current to be measured. The magnetic proportional current sensor measures the current to be measured based on the potential difference output from the magnetic field detecting bridge circuit according to the induction field.

The magnetic balance current sensor includes at least one magnetoresistive effect element according to an embodiment of the present invention and includes a magnetic field detecting bridge circuit having two outputs for generating a potential difference according to the induction field from a current to be measured and a feedback coil disposed near the magnetoresistive effect element and generating a cancellation magnetic field that cancels out the induction field. In the magnetic balance current sensor, the feedback coil is energized by the potential difference, and the current to be measured is measured based on the current flowing in the feedback coil when the induction field and the cancellation magnetic field cancel each other out into an equilibrium state.

The magnetoresistive effect element according to an embodiment of the present invention has at least one of the following Structure 1 and Structure 2.
(Structure 1) A magnetoresistive effect element having a layered structure composed of a fixed magnetic layer and a free magnetic layer stacked with a nonmagnetic material layer therebetween, wherein the magnetoresistive effect element includes a first antiferromagnetic layer on the free magnetic layer on the side opposite to the nonmagnetic material layer to generate an exchange coupling bias between itself and the free magnetic layer and to align the magnetization direction of the free magnetic layer in a prescribed direction in a state of permitting the magnetization to change; and the free magnetic layer includes a misfit-reducing layer disposed so as to be in contact with the first antiferromagnetic layer and decreasing the lattice mismatch of the free magnetic layer with respect to the first antiferromagnetic layer and a ferromagnetic layer consisting of a ferromagnetic material and disposed on the misfit-reducing layer on the side opposite to the first antiferromagnetic layer, wherein the ferromagnetic layer is a NiFeM layer (a layer consisting of NiFeM, where M consists of one or more elements selected from Ta, Cr, Nb, Rh, Zr, Mo, Al, Au, Pd, Pt, and Si).
(Structure 2) A magnetoresistive effect element having a layered structure composed of a fixed magnetic layer and a free magnetic layer stacked with a nonmagnetic material layer therebetween, wherein the magnetoresistive effect element includes a first antiferromagnetic layer on the free magnetic layer on the side opposite to the nonmagnetic material layer to generate an exchange coupling bias between itself and the free magnetic layer and to align the magnetization direction of the free magnetic layer in a prescribed direction in a state of permitting the magnetization to change; and the free magnetic layer includes a first layer containing one or more iron group elements and one or more platinum group elements and disposed so as to be in contact with the first antiferromagnetic layer and a ferromagnetic layer consisting of a ferromagnetic material and disposed on the first layer on the side opposite to the first antiferromagnetic layer, wherein the ferromagnetic layer is a NiFeM layer (a layer consisting of NiFeM, where M consists of one or more elements selected from Ta, Cr, Nb, Rh, Zr, Mo, Al, Au, Pd, Pt, and Si).

The embodiments described above are merely described to facilitate understanding of the present invention and are not intended to limit the present invention. Accordingly, each element disclosed in the embodiments is intended to include all design modification and equivalents belonging to the technical scope of the present invention.

For example, the first magnetoresistive effect element GMR11 shown in Fig. 3 has a so-called bottom pin structure having the fixed magnetic layer 21 between the free magnetic layer 23 and the substrate 29, but may has a so-called top pin structure having a free magnetic layer between a fixed magnetic layer and a substrate. The fixed magnetic layer 21 of the first magnetoresistive effect element GMR11 may have a layered structure composed of an antiferromagnetic layer and a ferromagnetic layer instead of a self-pinned structure, and the fixed magnetic layer 21 may be magnetized through magnetization of the ferromagnetic layer in a specific direction (in Fig. 3, leftward) by exchange coupling with the antiferromagnetic layer.

### EXAMPLES

The present invention will now be described in more detail by Examples and so on, but the scope of the present invention is not limited to these Examples and so on.

### (Example 1)

Prepared was a long pattern 12 of 4.0 µm × 80 µm consisting of a laminated film obtained by stacking seed layer 20: NiFeCr (42)/fixed magnetic layer 21 [first magnetic layer 21a: Co₄₀Fe₆₀ (19)/nonmagnetic intermediate layer 21b: Ru (3.6)/second magnetic layer 21c: Co₉₀Fe₁₀ (24)]/nonmagnetic material layer 22: Cu (20.5)/free magnetic layer 23 [ferromagnetic layer 23a: {conductive ferromagnetic layer 232a: Co₉₀Fe₁₀ (18)/NiFeM layer 231a: Ni_{81.8}Fe_{13.4}Nb_{4.8} (60) }/misfit-reducing layer 23b: Co₅₄Fe₆Pt₄₀ (10)] /first antiferromagnetic layer 24: Ir₂₂Mn₇₈ (60)/protective layer 25: Ta (100) in this order from the bottom on a substrate 29 provided with an insulating film. The figures in parentheses denote the layer thicknesses, and the unit thereof is angstrom. The misfit-reducing layer 23b of the long pattern 12 is also a layer containing one or more iron group elements (specifically, Co and Fe) and one or more platinum group elements (specifically, Pt) and is therefore also positioned as a first layer. Four magnetoresistive effect elements (first magnetoresistive effect elements GMR11 and GMR12 and second magnetoresistive effect elements GMR21 and GMR22) each having a meander shape including nine of the long patterns 12 were produced. A magnetic sensor 1 including these four magnetoresistive effect elements and having a full-bridge structure shown in Fig. 1 was produced. The meander shape of each magnetoresistive effect element was produced as follows. First of all, the above-described laminated film was uniformly formed on a substrate 29, and the laminated film was pattern-etched by, for example, a lift-off method to form a plurality of long patterns 12 on the substrate 29. The ends of the long patterns 12 were connected in series with an electrically conductive material to obtain a meander shape.

### (Example 2)

A long pattern 12 was obtained by stacking seed layer 20: NiFeCr (42)/fixed magnetic layer 21 [first magnetic layer 21a: Co₄₀Fe₆₀ (19)/nonmagnetic intermediate layer 21b: Ru (3.6)/second magnetic layer 21c: Co₉₀Fe₁₀ (24)]/nonmagnetic material layer 22: Cu (20.5)/free magnetic layer 23 [ferromagnetic layer 23a: {conductive ferromagnetic layer 232a: Co₉₀Fe₁₀ (10)/Ni_{82.5}Fe_{17.5} (10)/NiFeM layer 231a: Ni_{81.8}Fe_{13.4}Nb_{4.8} (60)} /misfit-reducing layer 23b: Co₅₄Fe₆Pt₄₀ (10)]/first antiferromagnetic layer 24: Ir₂₂Mn₇₈ (60)/protective layer 25: Ta (100) in this order from the bottom on a substrate 29 provided with an insulating film. The figures in parentheses denote the layer thicknesses, and the unit thereof is angstrom. The misfit-reducing layer 23b of the long pattern 12 is also a layer containing one or more iron group elements (specifically, Co and Fe) and one or more platinum group elements (specifically, Pt) and is therefore also positioned as a first layer. Four magnetoresistive effect elements (first magnetoresistive effect elements GMR11 and GMR12 and second magnetoresistive effect elements GMR21 and GMR22) each having a meander shape including nine of the long patterns 12 were produced. A magnetic sensor 1 including these four magnetoresistive effect elements and having a full-bridge structure shown in Fig. 1 was produced.

### (Comparative Example 1)

A long pattern was obtained by stacking seed layer: NiFeCr (42)/fixed magnetic layer [first magnetic layer: Co₄₀Fe₆₀ (19)/nonmagnetic intermediate layer: Ru second magnetic layer: Co₉₀Fe₁₀ (24)]/nonmagnetic material layer: Cu (20.5)/free magnetic layer [ferromagnetic layer: {Co₉₀Fe₁₀ (10)/Ni_{82.5}Fe_{17.5} (60)}/misfit-reducing layer: Co₅₄Fe₆Pt₄₀ (10)]/first antiferromagnetic layer: Ir₂₂Mn7₈ (60)/protective layer 25: Ta (100) in this order from the bottom on a substrate provided with an insulating film. The figures in parentheses denote the layer thicknesses, and the unit thereof is angstrom. The misfit-reducing layer of the long pattern is also a layer containing one or more iron group elements (specifically, Ni and Fe) and one or more platinum group elements (specifically, Pt) and is therefore also positioned as a first layer. Four magnetoresistive effect elements each having a meander shape including nine of the long patterns were produced. A magnetic sensor including these four magnetoresistive effect elements and having a full-bridge structure shown in Fig. 1 was produced.

### (Comparative Example 2)

A long pattern was obtained by stacking seed layer: NiFeCr (42)/fixed magnetic layer [first magnetic layer: Co₄₀Fe₆₀ (19)/nonmagnetic intermediate layer: Ru (3.6)/second magnetic layer: Co₉₀Fe₁₀ (24)]/nonmagnetic material layer: Cu (20.5)/free magnetic layer [Co₉₀Fe₁₀ (10)/Ni_{82.5}Fe_{17.5} (70)]/antiferromagnetic layer: Ir₂₂Mn₇₈ (80)/protective layer: Ta (100) in this order from the bottom on a substrate provided with an insulating film. The figures in parentheses denote the layer thicknesses, and the unit thereof is angstrom. Four magnetoresistive effect elements each having a meander shape including nine of the long patterns were produced. A magnetic sensor including these four magnetoresistive effect elements and having a full-bridge structure shown in Fig. 1 was produced.

### (Evaluation of characteristics of magnetic sensor)

The magnetic sensors produced in Examples 1 and 2 and Comparative Examples 1 and 2 were subjected to the following measurements.

First of all, the size (unit: Oe) of each exchange coupling bias was measured at environmental temperatures of 25°C and 85°C. The results are shown in Table 1.

The proportional sensitivity (unit: mV/mT) when the voltage at the input terminal V_{dd} was 3 V and the measurement magnetic field was ±2 mT was measured (environmental temperature: 25°C). The results are shown in Table 1.

The proportional sensitivities were measured with changing the environmental temperature from 25°C to 85°C to measure the proportional sensitivity temperature characteristics (ppm/°C). The results are shown in Table 1.

The degree of change in the proportional sensitivity after storage at an environmental temperature of 150°C for 1000 hours from the state before the storage (proportional sensitivity drift, unit: %) was measured. The results are shown in Table 1.

A hysteresis loop was obtained by changing the externally applied magnetic field, and the rate of the output range where the linearities of the externally applied magnetic field and the output were not maintained to the full scale of the output, (linearity, unit: %/F.S.), was measured. The results are shown in Table 1.

In the hysteresis loop, the rate of the hysteresis at an externally applied magnetic field of zero to the full scale of the output, (zero magnetic field hysteresis, unit: %/F.S.), was measured. The results are shown in Table 1.

Regarding the magnetoresistive effect element of each magnetic sensor, the elemental resistance (unit: Ω) and the temperature coefficient of resistance (TCR, unit: ppm/°C) were measured. The results are shown in Table 1.

**[Table 1]**

| | Example 1 | Example 2 | Comparative Example 1 | Comparative Example 2 |
|---|---|---|---|---|
| Proportional sensitivity (mV/mT) | 15.7 | 16.0 | 14.0 | 14.0 |
| Proportional sensitivity temperature characteristics (ppm/°C) | -430 | -500 | -550 | -420 |
| Proportional sensitivity drift (%) | -0.6 | -0.6 | -0.6 | -3.5 |
| Linearity (%/F.S.) | 0.41 | 0.38 | 0.43 | 0.55 |
| Zero magnetic field hysteresis (%/F.S.) | 0.25 | 0.26 | 0.24 | 0.42 |
| Elemental resistance (Ω) | 2860 | 2820 | 2180 | 2100 |
| TCR (ppm/°C) | 1030 | 1060 | 1800 | 1810 |

In the magnetic sensor of Comparative Example 1, since the magnetoresistive effect element of the magnetic sensor included a misfit-reducing layer, the proportional sensitivity drift was improved compared to the magnetic sensor of Comparative Example 2. The magnetic sensors of Examples also had improved proportional sensitivity drifts compared to the magnetic sensor of Comparative Example 2, as in the magnetic sensor of Comparative Example 1. In the magnetoresistive effect element of each of the magnetic sensors of Examples, since the free magnetic layer included a NiFeM layer (specifically, M is Nb), an increase in the elemental resistance and a decrease in the TCR were observed, compared to the magnetoresistive effect elements of the magnetic sensors of Comparative Examples.

### (Measurement of offset temperature characteristics)

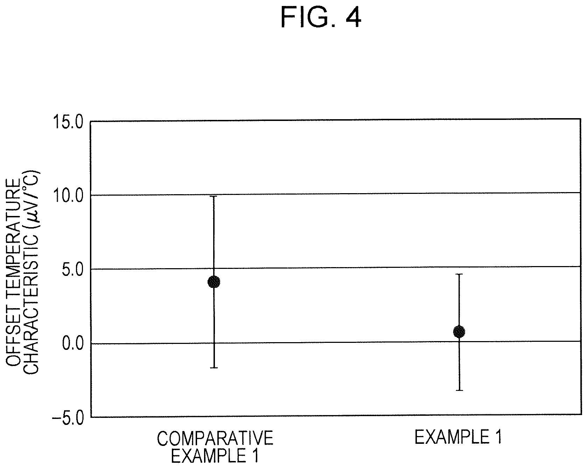

The magnetic sensor according to Example 1 and the magnetic sensor according to Comparative Example 1 were each produced for ten wafers, and the temperature characteristics (offset temperature characteristics, environmental temperature range: 25°C to 85°C, unit: µV/°C) of the values of sensor output Vₒᵤₜ when no external magnetic field was applied were measured. The results of measurement (mean value and 3σ value) are shown in Table 2 and Fig. 4.

**[Table 2]**

| | Comparative Example 1 | Example 1 |
|---|---|---|
| Mean value (µV/°C) | 4.1 | 0.6 |
| 3σ (µV/°C) | 5.8 | 3.9 |

As shown in Table 2 and Fig. 4, in the magnetic sensor of Example according to the present invention, the value of the offset temperature characteristics was close to 0 µV/°C compared to that in the magnetic sensor of Comparative Example 1. Accordingly, it was confirmed that the magnetic sensor according to the present invention hardly causes offset even if the environmental temperature changes and has excellent measurement accuracy.

### (Example 2)

A long pattern 12 of 4.0 µm × 80 µm was obtained by stacking seed layer 20: NiFeCr (42)/fixed magnetic layer 21 [first magnetic layer 21a: Co₄₀Fe₆₀ (19)/nonmagnetic intermediate layer 21b: Ru (3.6)/second magnetic layer 21c: Co₉₀Fe₁₀ (24)]/nonmagnetic material layer 22: Cu (20.5)/free magnetic layer 23 [ferromagnetic layer 23a: {conductive ferromagnetic layer 232a: Co₉₀Fe₁₀ (X)/NiFeM layer 231a: Ni_{81.8}Fe_{13.4}Nb_{4.8} (40) }/misfit-reducing layer 23b: Co₅₄Fe₆Pt₄₀ (10)]/first antiferromagnetic layer 24: Ir₂₂Mn7₈ (60)/protective layer 25: Ta (100) in this order from the bottom on a substrate 29 provided with an insulating film. The figures in parentheses denote the layer thicknesses, and the unit thereof is angstrom. The thickness X (unit: angstrom) of the conductive ferromagnetic layer 232a was set to different values from 5 angstroms to 45 angstroms by every 5 angstroms (Examples 2-1 to 2-9). The misfit-reducing layer 23b of the long pattern 12 was also a layer containing one or more iron group elements (specifically, Co and Fe) and one or more platinum group elements (specifically, Pt) and was therefore also positioned as a first layer. A first magnetoresistive effect element GMR11 having a meander shape including nine of the long patterns 12 was produced.

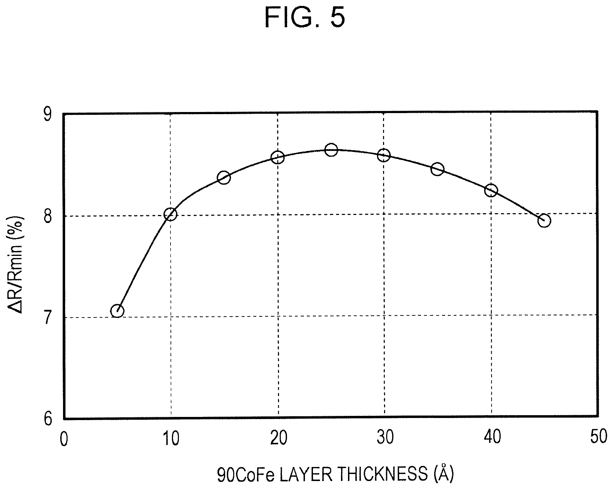

The resistance changing rate ΔR/Rmin (unit: %) of the produced first magnetoresistive effect element GMR11 was measured. The results of measurement are shown in Table 3 and Fig. 5.

**[Table 3]**

| | Thickness of 90CeFe layer (angstrom) | ΔR/Rmin (%) |
|---|---|---|
| Example 2-1 | 5 | 7.06 |
| Example 2-2 | 10 | 8.01 |
| Example 2-3 | 15 | 8.37 |
| Example 2-4 | 20 | 8.56 |
| Example 2-5 | 25 | 8.63 |
| Example 2-6 | 30 | 8.58 |
| Example 2-7 | 35 | 8.44 |
| Example 2-8 | 40 | 8.23 |
| Example 2-9 | 45 | 7.93 |

As shown in Table 3 and Fig. 5, in the conductive ferromagnetic layer 232a consisting of Co₉₀Fe₁₀, when the thickness thereof was 10 angstroms or more and 40 angstroms or less, the first magnetoresistive effect element GMR11 stably achieved a resistance changing rate ΔR/Rmin of 8% or more. When the thickness of the conductive ferromagnetic layer 232a was 20 angstroms or more and 30 angstroms or less, the magnetoresistive effect element stably achieved a resistance changing rate ΔR/Rmin of 8.5% or more.

### (Example 3)

A laminated film having a magnetoresistive effect was obtained by stacking seed layer 20: NiFeCr (42)/fixed magnetic layer 21 [first magnetic layer 21a: Co₄₀Fe₆₀ (19)/nonmagnetic intermediate layer 21b: Ru (3.6)/second magnetic layer 21c: Co₉₀Fe₁₀ (24)]/nonmagnetic material layer 22: Cu (20.5)/free magnetic layer 23 [ferromagnetic layer 23a: {conductive ferromagnetic layer 232a: (Co₉₀Fe₁₀ (25-X)/Co₇₀Fe₃₀ (X))/NiFeM layer 231a: Ni_{81.8}Fe_{12.4}Nb_{4.8} (40)}/misfit-reducing layer 23b: Co₅₄Fe₆Pt₄₀ (10)]/first antiferromagnetic layer 24: Ir₂₂Mn₇₈ (60)/protective layer 25: Ta (100) in this order from the bottom on a substrate 29 provided with an insulating film. The figures in parentheses denote the layer thicknesses, and the unit thereof is angstrom. The conductive ferromagnetic layer 232a had a total thickness of 25 angstroms and had a layered structure composed of a lower layer consisting of Co₇₀Fe₃₀ and an upper layer consisting of Co₉₀Fe₁₀ (excluding Examples 3-1 and 3-9). The thickness X (unit: angstrom) of the upper layer consisting of Co₇₀Fe₃₀ was set to different values from 0 angstrom to 25 angstroms (Examples 3-1 to 3-9).

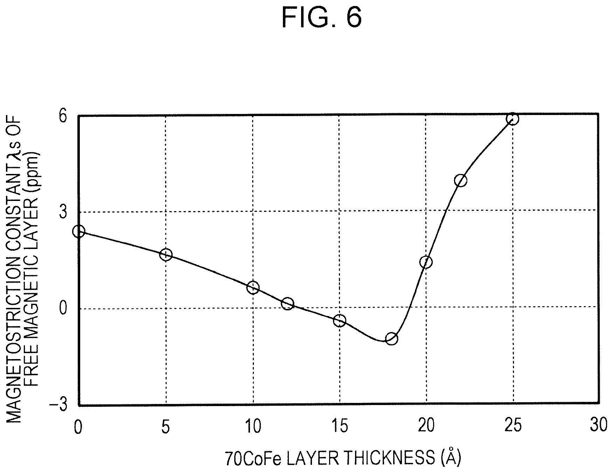

Unlike Examples 1 and 2 and Comparative Examples 1 and 2, the resulting laminated films were each directly, i.e., without being formed into a meander shape, subjected to measurement of the magnetostriction constant λs (unit: ppm) of the free magnetic layer 23. The results of measurement are shown in Table 4 and Fig. 6.

**[Table 4]**

| | Thickness of 90CeFe layer (angstrom) | Thickness of 70CeFe layer (angstrom) | Thickness of conductive ferromagnetic layer (angstrom) | Magnetostriction constant λs of free magnetic layer (ppm) |
|---|---|---|---|---|
| Example 3-1 | 25 | 0 | 25 | 2.42 |
| Example 3-2 | 20 | 5 | 25 | 1.67 |
| Example 3-3 | 15 | 10 | 25 | 0.63 |
| Example 3-4 | 13 | 12 | 25 | 0.13 |
| Example 3-5 | 10 | 15 | 25 | -0.41 |
| Example 3-6 | 7 | 18 | 25 | -0.99 |
| Example 3-7 | 5 | 20 | 25 | 1.40 |
| Example 3-8 | 3 | 22 | 25 | 3.93 |
| Example 3-9 | 0 | 25 | 25 | 5.85 |

As shown in Table 4 and Fig. 6, the results demonstrate that when the thickness of the upper layer consisting of Co₇₀Fe₃₀ was from 0 angstrom to 18 angstroms, that is, the thickness of the lower layer consisting of Co₉₀Fe₁₀ was from 7 angstroms to 25 angstroms, the magnetostrictive properties of the conductive ferromagnetic layer 232a were dominantly influenced by the lower layer consisting of Co₉₀Fe₁₀, and the magnetostriction constant λs of the free magnetic layer 23 was small. Specifically, the absolute values of magnetostriction constant λs were less than 2.5 ppm through the range of the lower layer consisting of Co₉₀Fe₁₀ from 7 angstroms to 25 angstroms. In contrast, when the thickness of the upper layer consisting of Co₇₀Fe₃₀ was 20 angstroms or more, the magnetostrictive properties of the conductive ferromagnetic layer 232a were dominantly influenced by the upper layer, and the magnetostriction constant λs highly changed according to the thickness of the upper layer. When the conductive ferromagnetic layer 232a consisted of Co₇₀Fe₃₀, the magnetostriction constant λs increased up to 6 ppm. This is probably caused by that since an upper layer consisting of Co₇₀Fe₃₀ is fundamentally stabilized by having a bcc structure, the component of the bcc structure increases when the thickness of the upper layer is 20 angstroms or more. In contrast, when the thickness of the upper layer consisting of Co₇₀Fe₃₀ is smaller than 20 angstroms, it is conceived that since the lower layer consisting of Co₉₀Fe₁₀ has an fcc structure, the influence of the lower layer becomes dominant, and the upper layer consisting of Co₇₀Fe₃₀ grows as an fcc structure to reduce the magnetostriction constant λs. It was thus confirmed that an increase in the content of the CoFe alloy having an fcc structure of the conductive ferromagnetic layer 232a can reduce the magnetostriction constant λs of the free magnetic layer 23.

### (Example 4-1)

A long pattern 12 of 4.0 µm × 80 µm was obtained by stacking seed layer 20: NiFeCr (42)/fixed magnetic layer 21 [first magnetic layer 21a: Co₄₀Fe₆₀ (19)/nonmagnetic intermediate layer 21b: Ru (3.6)/second magnetic layer 21c: Co₉₀Fe₁₀ (24)]/nonmagnetic material layer 22: Cu (20.5)/free magnetic layer 23 [ferromagnetic layer 23a: {conductive ferromagnetic layer 232a: (Co₉₀Fe₁₀ (13)/Co₇₀Fe₃₀ (12))/NiFeM layer 231a: Ni_{81.8}Fe_{13.4}Nb_{4.8} (40)}/misfit-reducing layer 23b: Co₅₄Fe₆Pt₄₀ (10)]/first antiferromagnetic layer 24: Ir₂₂Mn7₈ (60)/protective layer 25: Ta (100) in this order from the bottom on a substrate 29 provided with an insulating film. The figures in parentheses denote the layer thicknesses, and the unit thereof is angstrom. The misfit-reducing layer 23b of the long pattern 12 was also a layer containing one or more iron group elements (specifically, Co and Fe) and one or more platinum group elements (specifically, Pt) and was therefore also positioned as a first layer. Four magnetoresistive effect elements (first magnetoresistive effect elements GMR11 and GMR12 and second magnetoresistive effect elements GMR21 and GMR22) each having a meander shape including nine of the long patterns 12 were produced. A magnetic sensor 1 including these four magnetoresistive effect elements and having a full-bridge structure shown in Fig. 1 was produced. The resulting magnetic sensor 1 was sealed with a resin for molding to produce a mold package.

### (Example 4-2)

Magnetoresistive effect elements were produced as in Example 4-1 except that the conductive ferromagnetic layer 232a was constituted of a layer consisting of Co₉₀Fe₁₀ and having a thickness of 25 angstroms, and a mold package was further produced as in Example 4-1 using these magnetoresistive effect elements.

A pressure of 1.5 MPa (8 kgf) was applied to each of the upper and lower surfaces of the produced mold package according to each Example. The variation amount of the offset voltage (unit: mV) of the magnetic sensor 1 at the zero magnetic field was measured after the application of the pressure. The results of measurement are shown in Table 5. A laminated film having the same film structure as that of the magnetoresistive effect element was separately prepared, and the magnetostriction constant λs of this laminated film (i.e., the state before being formed into a meander shape) was measured.

**[Table 5]**

| | Magnetostriction constant λs of free magnetic layer (ppm) | Offset variation amount (mV) |
|---|---|---|
| Example 4-1 | 0.1 | 3.6 |
| Example 4-2 | 2.4 | 60.5 |

As shown in Table 5, in the magnetic sensor 1 of the mold package according to Example 4-1 including a free magnetic layer 23 having a small magnetostriction constant λs, the variation amount of the offset voltage was small. In contrast, it was confirmed that in the magnetic sensor of the mold package according to Example 4-2 including a free magnetic layer 23 having a larger magnetostriction constant λs compared to that in Example 4-1, the variation amount of the offset voltage was large.

### Industrial Applicability

A magnetic sensor including a magnetoresistive effect element according to an embodiment of the present invention can be suitably used as a component of a current sensor that is used in, for example, infrastructure-related facilities, such as columnar transformers; and transportation apparatuses, such as electric cars and hybrid cars.

### Reference Signs List

- 1: magnetic sensor
- GMR11, 12: first magnetoresistive effect element
- GMR21, 22: second magnetoresistive effect element
- 31: full-bridge circuit
- 32: first half bridge circuit
- 33: second half bridge circuit
- V_{dd}: input terminal
- V₁: first midpoint potential
- V₂: second midpoint potential
- Vₒᵤₜ: sensor output
- 40: differential amplifier
- 12: long pattern
- 13: conductive part
- 14: connecting terminal
- D1: longitudinal direction
- D2: width direction
- 20: seed layer
- 21: fixed magnetic layer
- 21a: first magnetic layer
- 21b: nonmagnetic intermediate layer
- 21c: second magnetic layer
- 22: nonmagnetic material layer
- 23: free magnetic layer
- 23a: ferromagnetic layer
- 231a: NiFeM layer
- 232a: conductive ferromagnetic layer
- 23b: misfit-reducing layer
- 24: first antiferromagnetic layer
- 25: protective layer
- 29: substrate
- F: magnetization direction

## Claims

1. A magnetic sensor comprising a magnetoresistive effect element having a sensitivity axis in a specific direction, wherein
the magnetoresistive effect element has a layered structure composed of a fixed magnetic layer and a free magnetic layer stacked with a nonmagnetic material layer therebetween on a substrate; and
the magnetoresistive effect element includes a first antiferromagnetic layer on the free magnetic layer on the side opposite to the nonmagnetic material layer so as to generate an exchange coupling bias between itself and the free magnetic layer to align the magnetization direction of the free magnetic layer in a predetermined direction in a state of permitting the magnetization to change, wherein
the free magnetic layer includes a misfit-reducing layer disposed so as to be in contact with the first antiferromagnetic layer and decreasing the lattice mismatch of the free magnetic layer with respect to the first antiferromagnetic layer and a ferromagnetic layer consisting of a ferromagnetic material disposed on the misfit-reducing layer on the side opposite to the first antiferromagnetic layer; and
the ferromagnetic layer includes a NiFeM layer (M is one or more elements selected from Ta, Cr, Nb, Rh, Zr, Mo, Al, Au, Pd, Pt, and Si).

2. The magnetic sensor according to Claim 1, wherein the misfit-reducing layer and the ferromagnetic layer each have a face-centered cubic (fcc) structure, and the lattice spacing in the fcc(111) plane of the misfit-reducing layer is larger than the lattice spacing in the fcc(111) plane of the ferromagnetic layer.

3. The magnetic sensor according to Claim 1 or 2, wherein the misfit-reducing layer contains one or more iron group elements and one or more platinum group elements.

4. A magnetic sensor comprising a magnetoresistive effect element having a sensitivity axis in a specific direction, wherein
the magnetoresistive effect element has a layered structure composed of a fixed magnetic layer and a free magnetic layer stacked with a nonmagnetic material layer therebetween on a substrate; and
the magnetoresistive effect element includes a first antiferromagnetic layer on the free magnetic layer on the side opposite to the nonmagnetic material layer so as to generate an exchange coupling bias between itself and the free magnetic layer to align the magnetization direction of the free magnetic layer in a predetermined direction in a state of permitting the magnetization to change, wherein
the free magnetic layer includes a first layer containing one or more iron group elements and one or more platinum group elements and disposed so as to be in contact with the first antiferromagnetic layer and a ferromagnetic layer consisting of a ferromagnetic material disposed on the first layer on the side opposite to the first antiferromagnetic layer; and
the ferromagnetic layer includes a NiFeM layer (M is one or more elements selected from Ta, Cr, Nb, Rh, Zr, Mo, Al, Au, Pd, Pt, and Si).

5. The magnetic sensor according to any one of Claims 1 to 4, wherein the first antiferromagnetic layer contains a platinum group element and Mn.

6. The magnetic sensor according to any one of Claims 1 to 5, wherein the first antiferromagnetic layer is made of at least one of IrMn and PtMn.

7. The magnetic sensor according to any one of Claims 1 to 6, wherein the NiFeM layer consists of NiFeNb.

8. The magnetic sensor according to any one of Claims 1 to 7, wherein the ferromagnetic layer further includes a conductive ferromagnetic layer located to be closer to the nonmagnetic material layer side than the NiFeM layer and having an electrical resistivity lower than that of the NiFeM layer.

9. The magnetic sensor according to Claim 8, wherein the conductive ferromagnetic layer is located so as to be in contact with the nonmagnetic material layer.

10. The magnetic sensor according to Claim 8 or 9, wherein the conductive ferromagnetic layer consists of a CoFe layer.

11. The magnetic sensor according to Claim 8 or 9, wherein the conductive ferromagnetic layer contains a CoFe alloy having a face-centered cubic structure.

12. The magnetic sensor according to Claim 11, wherein the conductive ferromagnetic layer consists of a CoFe alloy having a face-centered cubic structure and has a thickness of 10 angstroms or more and 40 angstroms or less.

13. A current sensor comprising the magnetic sensor according to any one of Claims 1 to 12.
